# EUROPEAN PATENT APPLICATION

(11) **EP 4 517 844 A1**
(43) Date of publication of application: **05.03.2025**
(21) Application number: 23796236.0
(22) Date of filing: 20.04.2023
(51) Int. Cl.: H01L 33/20

(54) **LIGHT EMITTING ELEMENT AND METHOD FOR MANUFACTURING SAME**

(30) Priority: 27.04.2022 JP 2022073796
(71) Applicant: Shin-Etsu Handotai Co., Ltd., Tokyo 100-0004 (JP)
(72) Inventor: ISHIZAKI, Junya, Annaka-shi, Gunma 379-0196 (JP)
(74) Representative: Röthinger, Rainer
(86) International application number: PCT/JP2023/015765
(87) International publication number: WO 2023/210494

(57) **Abstract**

The present invention is a method for producing a light emitting device to produce a plurality of light emitting devices, the method includes the steps of growing an epitaxial layer including a light emitting layer on a starting substrate, and forming an isolation groove for device formation in the light emitting layer, in which respective plane view shapes of the plurality of the light emitting devices to be produced are line-symmetric hexagons having a symmetry axis with two sides parallel to the symmetry axis, in which length of the two parallel sides is longer than that of other four sides and two vertex angles through which the symmetry axis passes are 90° or more and less than 180°, and the plurality of the light emitting devices to be produced are isolated by the isolation groove of a predetermined width, and the isolation groove is formed so as to arrange the plurality of light emitting devices without a gap via the isolation groove. Thereby the light emitting device and the method for producing the light emitting device, in which yield of the device per a single wafer is improved without reducing yield during moving and mounting, are provided.

## Description

### TECHNICAL FIELD

The present invention relates to a light emitting device and a method for producing the same.

### BACKGROUND ART

Two types of micro light emitting diode (micro-LED) displays are present: a form of a monochromatic display realized by fine processing using a monochromatic micro-LED, and a full-color display realized by transferring RGB tri-color LEDs from a donor substrate, respectively.

Conventionally, in the form of the full-color display realized by transferring respective RGB chips, transferring cost has been high, causing a producing cost of the micro-displays to skyrocket.

In recent years, the EZ-PETAMP series, SQDP series, SQDP-G series, and SQRP series manufactured by Shine-Etsu Chemical Co., Ltd. have been developed, which can significantly reduce mounting costs by transferring micro-LEDs from a starting substrate to a donor substrate and mounting thereon by adhering chips to the donor substrate having a silicone film formed on synthetic quartz and irradiating an interface between the starting substrate and an epitaxial layer with ultraviolet laser to sublimate the interface.

However, this method is effective for, e.g., a GaN-based LED formed on a sapphire substrate, but cannot be applied to, e.g., an AlGaInP-based LED formed on a GaAs substrate.

In order to realize the above transfer by EZ-PETAMP, a technique is required to remove the starting substrate after bonding an epitaxial functional layer to a permanent substrate, thereby realizing the transfer.

Patent Document 1 discloses a technique of bonding a semiconductor epitaxial substrate and a temporary support substrate by thermocompression via a dielectric layer, and a technique of separating the temporary support substrate and the epitaxial functional layer by wet etching.

By bonding a sapphire substrate and an LED device portion via a bonding material (adhesive) such as BCB (benzocyclobutene), the same step (EZ-PETAMP) as the structure of a GaN-based LED formed on the sapphire substrate can be performed.

By combining the GaN-based LED and the AlGaInP-based LED, pixels that can display RGB colors can be formed. When a display, being a display device, is formed by using RGB light emitting devices, a large number of LEDs are required to be mounted, and thus, it is essential to minimize material cost per one die to suppress overall cost.

Although Patent Document 1 discloses the technique of bonding the semiconductor epitaxial substrate and the temporary support substrate by thermocompression via the dielectric layer, and the technique of separating the temporary support substrate and the epitaxial functional layer by wet etching as described above, this technique is not about an optimal device form of the micro-LEDs bonded via BCB layer, etc., and a technique for reducing the material cost of LED itself is not disclosed in this prior technique.

### CITATION LIST

### PATENT LITERATURE

Patent Document 1: JP 2021-27301 A
Patent Document 2: JP 2017-17163 A
Patent Document 3: JP 2000-164930 A
Patent Document 4: JP 2006-135309 A
Patent Document 5: JP 2016-164970 A
Patent Document 6: JP 2016-207870 A

### SUMMARY OF INVENTION

### TECHNICAL PROBLEM

Although micro-LED mounting cost has been reduced by the above EZ-PETAMP step, a unit cost per micro-LED is required to be reduced. However, space efficiency of a conventional rectangular die is not high, and as long as the rectangular die shape is selected, a theoretical number of dice obtained from a wafer is uniquely determined when a light-emitting area is defined as constant. This is because when LEDs for mounting, accompanied by a transfer step, are formed, devices move vertically during transferring, and a gap (isolation width between devices) between the LED devices is required to match the tolerance of the movement. The area, including the device isolation width, is the area required for the actual devices, and the isolation width between devices cannot be set to zero; consequently, the area, including the area of the LED devices themselves and the isolation width between devices, is the area required for device formation.

As a technique for minimizing the isolation width between devices, a technique adopting the closest packed structure based on regular hexagons has been disclosed in Patent Document 2. However, the regular hexagonal shape is not sufficient as a die shape for micro-LEDs with moving and mounting.

Especially in the transfer of micro-LEDs, a device wiring method by a wire-bonding is not used because a die size is very small (e.g., less than 100 µm). Although a bump may be used in some cases, flip mounting, in which an electrode formed on the LED device and an electrode on a mounting substrate are directly bonded, is generally used.

In the case of flip mounting, a form in which two electrodes of different polarity are formed on an upper surface is the easiest for mounting and is, therefore, a frequently adopted form. However, because zero mounting positional tolerance is impossible during the transfer, the mounting tolerance on the order of µm is required. The electrodes with different polarity are formed on the same surface, the larger the clearance therebetween, the larger the mount tolerance can be. Based on the above requirements, micro-LEDs are recognized to have a requirement for a rectangular shape, as shown in Patent Document 3.

However, in the case of a circle, square, regular hexagon, and other regular polygon, the clearance cannot be obtained beyond a size of an outer edge of the die. As shown in Patent Documents 4, 5, and 6, etc., a technique is disclosed, in which the electrodes are arranged closer to the outer edge portion to maximize clearance. However, a pad electrode portion is too small compared to the die size. In order to obtain ohmic contact, when resistance between the electrode and an interface is constant, the ohmic resistance is not lowered to an operable level unless the pad electrode portion is larger than a certain area. The electrode area disclosed in the prior technique is obviously small, and if applied to micro-LED as it is, the ohmic contact resistance becomes too large, and the micro-LED formed according to the prior technique does not operate properly.

In view of the above points, it has been considered that designing a rectangular die shape with the electrodes at ends in a major axis direction is optimum for the micro-LED, as shown in Patent Document 3.

However, in this design, the only method to increase yield of the number of dice that can be produced from a single wafer is to narrow the isolation width between devices when the device area is determined, and there is no other way to increase the yield. When the isolation width between devices is narrowed, the yield during moving and mounting is reduced; therefore, the method of increasing yield by narrowing and improving the isolation width between devices required for moving and transferring has a limit, and the method to increase the yield further has not been disclosed in the prior technique.

The present invention has been made in view of the above-described problem. An object of the present invention is to provide a method for producing a light emitting device in which the yield of the device per a single wafer is improved without decreasing the yield during moving and transferring.

### SOLUTION TO PROBLEM

To achieve the above object, the present invention provides a method for producing a light emitting device to produce a plurality of light emitting devices, the method comprising the steps of:
growing an epitaxial layer including a light emitting layer on a starting substrate; and
forming an isolation groove for device formation in the light emitting layer, wherein
respective plane view shapes of the plurality of the light emitting devices to be produced are line-symmetric hexagons having a symmetry axis with two sides parallel to the symmetry axis, in which length of the two parallel sides is longer than that of other four sides and two vertex angles through which the symmetry axis passes are 90° or more and less than 180°, and
the plurality of the light emitting devices to be produced are isolated by the isolation groove of a predetermined width, and the isolation groove is formed so as to arrange the plurality of light emitting devices without a gap via the isolation groove.

According to the method for producing a light emitting device, the light emitting device can be produced, which has the shape having the plane view shape of the line-symmetric hexagon, sides parallel to the symmetry axis, length of the parallel sides longer than that of the other sides, and the two vertex angles through which the symmetry axis passes being 90° or more and less than 180°. Thereby, a yield of the light emitting device per a single wafer can be improved compared to that of a light emitting device having a rectangular plane view shape.

In this case, after the step of growing the epitaxial layer, the method can further comprise a step of bonding a transparent substrate to the epitaxial layer via a bonding material and removing the starting substrate.

In particular, when the starting substrate is not the transparent substrate, transferring the epitaxial layer to the transparent substrate in this way allows the application of a technique that is supposed to be performed to the substrate with the light emitting device formed on the transparent substrate.

Moreover, the two vertex angles can be 90° or more and 120° or less.

By setting the vertex angles within this range, the yield of the light emitting device per a single wafer can be further improved.

Moreover, a distance between the two sides parallel to the symmetry axis can be 1 µm or more and 100 µm or less.

The present invention is particularly effective for producing a micro-LED having a distance between parallel sides of 1 to 100 µm.

In addition, it is preferred that the isolation groove is formed by an ICP dry etching method.

The formation of the isolation groove by such an ICP dry etching method can be performed precisely and easily.

Moreover, it is preferred that the transparent substrate is any of sapphire, quartz, or glass.

In addition, these substrates can be suitably used as the transparent substrate, particularly, the substrate having a high transmissiveness to a laser can be selected.

Moreover, the bonding material can be at least any of benzocyclobutene, fluororesin, or epoxy resin.

These bonding materials can be suitably used as a bonding material.

Moreover, the present invention provides a light emitting device, wherein
the light emitting device has a shape having a plane view shape of a line-symmetric hexagon with a symmetry axis, two sides parallel to the symmetry axis, length of the two parallel sides longer than that of other four sides, and two vertex angles through which the symmetry axis passes being 90° or more and less than 180°.

In such a light emitting device, by forming electrodes in a triangular portion of the hexagonal shape, including vertex potions through which the symmetry axis passes, an area ratio of the light emitting layer to the total area of the device having the light emitting layer can be increased; and by setting the length of the parallel sides longer than that of the other sides, generation of short circuit can be suppressed due to misalignment during mounting.

In this case, the light emitting device may be bonded to a transparent substrate via a bonding material.

When the light emitting device is bonded to the transparent substrate via the bonding material in such a way, a technique can be applied, which is supposed to the substrate with the light emitting device formed on the transparent substrate.

In addition, it is preferred that the two vertex angles are 90° or more and 120° or less.

By setting the vertex angles in this range, an area ratio of the light emitting layer to the total area of the device having the light emitting layer can be further increased.

Moreover, a distance between the two sides parallel to the symmetry axis can be 1 µm or more and 100 µm or less.

The present invention is particularly effective for applying to a micro-LED in which a distance between the sides parallel is 1 to 100 µm.

It is preferred that the transparent substrate is any of sapphire, quartz, or glass.

These substrates can be suitably used as the transparent substrate, particularly, can be selected so as to increase transmissiveness to a laser.

Furthermore, it is preferred that the bonding material is at least any of benzocyclobutene, fluororesin, or epoxy resin.

These bonding materials can be suitably used as a bonding material.

### ADVANTAGEOUS EFFECTS OF INVENTION

According to the inventive method for producing a light emitting device, the light emitting device can be produced in which the shape of the device has the plane view shape of the line-symmetric hexagon, the sides parallel to the symmetry axis, length of the parallel sides longer than that of other sides, and two vertex angles through which the symmetry axis passes being 90° or more and less than 180°. Thereby the yield of the light emitting device per a single wafer can be improved compared to that of the rectangular device. In addition, by setting the length of the parallel sides longer than the other sides, the generation of short circuit can be suppressed due to misalignment during mounting. Moreover, when the vertex angle is 90° or more, the mechanical strength of the vertex portion of the triangular shape can be prevented from weakening, and cracking at the triangular shape can be suppressed.

Moreover, in the inventive light emitting device, by forming electrodes in the triangular portion of the hexagonal shape, including vertex potions through which the symmetry axis passes, the area ratio of the light emitting layer to the total area of the device having the light emitting layer can be increased; and by setting the length of the parallel sides longer than that of the other sides, generation of short circuit can be suppressed due to misalignment during mounting.

### BRIEF DESCRIPTION OF DRAWINGS

FIG. 1 is a schematic cross-sectional view illustrating a part of the first embodiment of a method for producing a light emitting device according to the present invention.
FIG. 2 is a schematic cross-sectional view illustrating another part of the first embodiment of a method for producing a light emitting device according to the present invention.
FIG. 3 is a schematic cross-sectional view illustrating another part of the first embodiment of a method for producing a light emitting device according to the present invention.
FIG. 4 is a schematic cross-sectional view illustrating another part of the first embodiment of a method for producing a light emitting device according to the present invention.
FIG. 5 is a schematic plane view illustrating a shape of one light emitting layer in the first embodiment of a method for producing a light emitting device according to the present invention.
FIG. 6 is a schematic plane view illustrating respective parts of one light emitting layer in the first embodiment of a method for producing a light emitting device according to the present invention.
FIG. 7 is a schematic plane view illustrating a state of a plurality of light emitting layers being arrayed in the first embodiment of a method for producing a light emitting device according to the present invention.
FIG. 8 is a schematic plane view illustrating an arrangement position of contact pads in a shape of one light emitting layer in the first embodiment of a method for producing a light emitting device according to the present invention.
FIG. 9 is a schematic cross-sectional view illustrating another part of the first embodiment of a method for producing a light emitting device according to the present invention.
FIG. 10 is a schematic cross-sectional view illustrating another part of the first embodiment of a method for producing a light emitting device according to the present invention.
FIG. 11 is a schematic view illustrating a state of transfer of a plurality of light emitting devices according to the present invention.
FIG. 12 is a schematic plane view illustrating a shape of a light emitting device used in Comparative Example.
FIG. 13 is a schematic plane view illustrating an arrangement position of contact pads in a shape of a light emitting device used in Comparative Example.

### DESCRIPTION OF EMBODIMENTS

Hereinafter, the present invention will be described in detail. However, the present invention is not limited thereto.

As described above, a method for producing a light emitting device has been desired in which yield of a device per a single wafer is improved without decreasing yield during moving and mounting.

The present inventor has earnestly studied the above problem and found out to form a shape of the light emitting device so as to have a specific hexagonal shape. This finding has led to the completion of the present invention.

The present invention is a method for producing a light emitting device to produce a plurality of light emitting devices, the method comprising the steps of:
growing an epitaxial layer including a light emitting layer on a starting substrate; and
forming an isolation groove for device formation in the light emitting layer, wherein
respective plane view shapes of the plurality of the light emitting devices to be produced are line-symmetric hexagons having a symmetry axis with two sides parallel to the symmetry axis, in which length of the two parallel sides is longer than that of other four sides and two vertex angles through which the symmetry axis passes are 90° or more and less than 180°, and
the plurality of the light emitting devices to be produced are isolated by the isolation groove of a predetermined width, and the isolation groove is formed so as to arrange the plurality of light emitting devices without a gap via the isolation groove.

In addition, the inventive light emitting device is a light emitting device, wherein
the light emitting device has a shape having a plane view shape of a line-symmetric hexagon with a symmetry axis, two sides parallel to the symmetry axis, length of the two parallel sides longer than that of other four sides, and two vertex angles through which the symmetry axis passes being 90° or more and less than 180°.

Hereinafter, the present invention will be described in detail with reference to the drawings. However, the present invention is not limited thereto. In the following, embodiments of the present invention are described exemplifying the first embodiment and the second embodiment. The similar components in the respective embodiments are described with attaching the same reference signs in the drawings. Note that some overlapping descriptions are partially omitted.

### (First Embodiment)

First, the first embodiment is described. The first embodiment is an embodiment including a step of growing an epitaxial layer on a starting substrate, then bonding a transparent substrate to the epitaxial layer via a bonding material and removing the starting substrate.

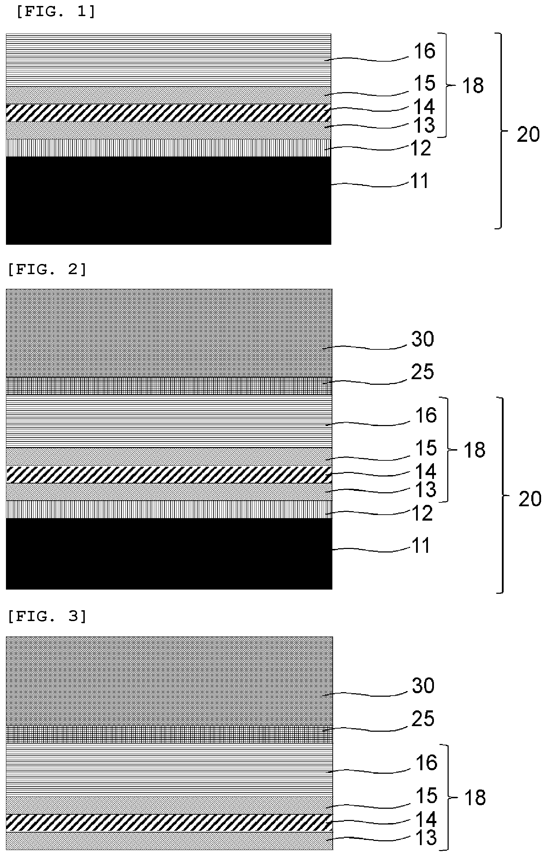

To begin with, as shown in FIG. 1, an epitaxial layer 18, including a light emitting layer, is grown on a starting substrate 11. More specifically, the step is as follows.

First, as shown in FIG. 1, an etching stop layer 12 is epitaxially grown on a first conductivity-type starting substrate 11 made of, e.g., GaAs. The etching stop layer 12 can be formed, for example, after laminating a first conductivity-type GaAs buffer layer, followed by growing a first conductivity-type GaInP first etching stop layer of, e.g., 0.1 µm, and, for example, a first conductivity-type GaAs second etching stop layer of, e.g., 0.1 µm. Moreover, an epitaxial wafer 20 including an epitaxial layer 18 is provided in which, for example, a first conductivity-type AlGaInP first cladding layer 13 of a thickness of, e.g., 1.0 µm, for example, a non-doped AlGaInP active layer 14, for example, a second conductivity-type AlGaInP second cladding layer 15 of, e.g., 1.0 µm, a second conductivity-type GaInP intermediate layer (not shown) of, e.g., 0.1 µm, and further, for example, a second conductivity-type GaP window layer 16 of, e.g., a thickness of 6 µm are sequentially grown on the etching stop layer 12. At this point, from the first cladding layer 13 to the second cladding layer 15 is referred to as a double-hetero (DH) structure portion (FIG. 1) and corresponds to the light emitting layer. That is, the epitaxial layer 18 includes the light emitting layer. Note that materials of the epitaxial layer 18 are not limited to these and the materials having the light emitting layer (light emitting device structure) may be used as described above.

In the present invention, after the step of growing such an epitaxial layer 18, the method can further include a step of bonding a transparent substrate 30 to the epitaxial layer 18 via a bonding material 25 and removing the starting substrate 11 as shown in FIGS 2 and 3. More specifically, the step is as follows.

First, as shown in FIG. 2, the epitaxial wafer 20 is spin-coated thereon with benzocyclobutene (BCB), being a thermosetting bonding material, as a bonding material 25 and then by facing, superimposing, and thermo-compressing with, for example, a sapphire wafer (transparent substrate 30) which is a to-be-bonded wafer; and then a first epitaxial bonded substrate is produced, in which the epitaxial wafer 20 and the sapphire wafer (transparent substrate 30) are bonded via the BCB (bonding material 25). When BCB is coated by spin-coating, a designed film thickness can be, for example, 0.6 µm, but not limited to this thickness, and the same effect can be obtained even when the thickness is equal to, or thicker or thinner than this thickness.

Pressurizing and bonding can be performed under bonding conditions in this case, including, for example, a temperature of 200°C or more and 400°C or less and a pressure of 1.2 N/cm² or more.

In addition, a material of the to-be-bonded substrate, as the transparent substrate 30 in this case, is not limited to sapphire, but any material can be selected as long as flatness is guaranteed. Quartz or glass, etc., may be selected other than sapphire.

Moreover, the bonding material 25 is not limited to BCB, and fluororesin, epoxy resin, etc., can be used. Note that the BCB is not limited to a case having a layered coating but may also be patterned in an isolated island shape, a line shape, or other shapes using a photosensitive BCB to perform the bonding step.

Then, as shown in FIG. 3, the starting substrate 11 (for example, GaAs starting substrate) is removed by wet etching, subsequently, the etching stop layer 12 is also removed. When the etching stop layer 12 includes the first etching stop layer and the second etching stop layer; first, the first etching stop layer is exposed by etching, then the etchant is switched to remove the second etching stop layer, and then the epitaxial layer 18 (first cladding layer 13 in epitaxial layer 18) can be exposed. Thereby a second epitaxial bonded substrate that retains only the double-hetero (DH) structure portion (first cladding layer 13, active layer 14, second cladding layer 15) and the window layer 16 can be produced (FIG. 3).

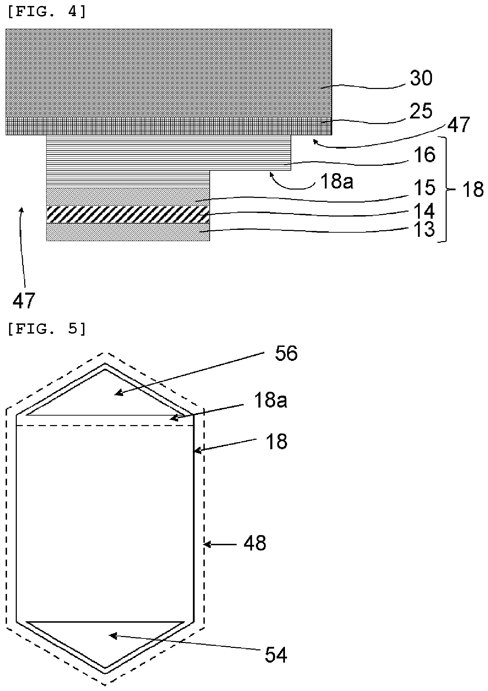

Next, an isolation groove 47 for device formation is formed in the light emitting layer (see FIG. 4). The formation of the isolation groove 47 is preferably formed by an ICP dry etching method because of simplicity and high precision. More specific methods are described, referring to FIGs 4 to 8.

In this step, a pattern is first formed by a photolithography method, as shown in FIG. 4, and device isolation processing is performed by ICP (inductively coupled plasma). Gases used for ICP can be chlorine and argon. The ICP processing can be performed twice, including the device isolation step to expose the bonding material 25 layer (BCB layer) and the exposure step to expose the window layer 16 (GaP window layer). Further, in this formation of the isolation groove 47, the case is not limited to such the case where the window layer 16 (GaP window layer) is exposed (FIG. 4), and it is only required that the active layer 14 is isolated; and the same effect can be obtained when the second cladding layer 15 is exposed instead of the exposure of the window layer 16 (GaP window layer). FIG. 4 shows 18a as a region where an underlayer of the light emitting layer is exposed. FIG. 4 shows the case where the window layer 16 is exposed as the underlayer exposed region 18a.

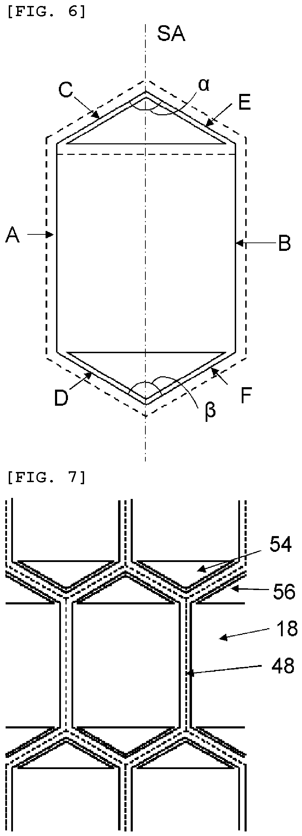

In the method for producing a light emitting device to produce a plurality of light emitting devices, which includes a step for growing the epitaxial layer 18 having the light emitting layer on the starting substrate 11 and a step for forming the isolation groove to the light emitting layer for device formation as described above; in the present invention, respective plane view shapes of a plurality of light emitting devices to be produced are a predetermined hexagonal shape as shown in FIGs 5 to 8 when the device isolation step (the step to form the isolation groove to the light emitting layer for the device formation) is performed. This hexagonal shape is a line-symmetric hexagon having a symmetry axis with two sides parallel to the symmetry axis, in which length of the two parallel sides is longer than that of the other four sides and two vertex angles through which the symmetry axis passes are 90° or more and less than 180°. In this case, the two vertex angles are preferably 90° or more and 120° or less. Moreover, in the present invention, the plurality of the light emitting devices to be produced are isolated by the isolation groove of a predetermined width, and the isolation groove is formed so as to arrange the plurality of light emitting devices without a gap via the isolation groove (see FIG. 7). Such an arrangement is similar to an arrangement which is referred to as a honeycomb structure when arranged in regular hexagons.

The plane view shape of one light emitting device is described with reference to FIG. 5. FIG. 5 is the plane view shape of the epitaxial layer 18 having the light emitting layer being device-isolated by the isolation groove 47 through each step in FIGs 1 to 4. In the hexagonal shape, a region indicated by reference sign 54 in FIG. 5 is a position of an upper electrode 54 described later, and a region indicated by reference sign 56 in FIG. 5 is a position of a lower electrode 56 described later. Moreover, a triangle region around the lower electrode 56 (a region of reference sign 18a separated by a dashed line in the hexagon shown by a solid line) is the underlayer exposed region 18a shown in FIG. 4. Furthermore, a dashed line outside the hexagon which is indicated by a solid line in FIG. 5 is a device isolation intermediate line 48. The device isolation intermediate line 48 indicates an intermediate line of the isolation groove 47 between respective light emitting layers isolated by the device isolation. FIG. 7 shows a state of the light emitting layers of FIG. 5 in a plurality of arrays (underlayer exposed region 18a is omitted from the drawings).

Furthermore, the shape of the light emitting device of the present invention is described with reference to FIG. 6. The hexagonal shape shown in FIG. 6 corresponds to the shape of the light emitting layer in FIG. 5. The hexagonal shape shown in FIG. 6 is the line-symmetric hexagon having a symmetry axis SA. Further, this hexagonal shape has two sides parallel to the symmetry axis SA (side A and side B), and the length of the two parallel sides (side A and side B) is longer than other four sides (side C, side D, side E, and side F). Moreover, two vertex angles (α and β) through which the symmetry axis SA passes are 90° or more and less than 180°.

In the present invention, the light emitting device in the hexagonal shape identified in this way is further isolated by the isolation groove having the predetermined width as shown in FIG. 7, and the isolation grooves are formed so as to arrange a plurality of light emitting devices without gaps via the isolation grooves.

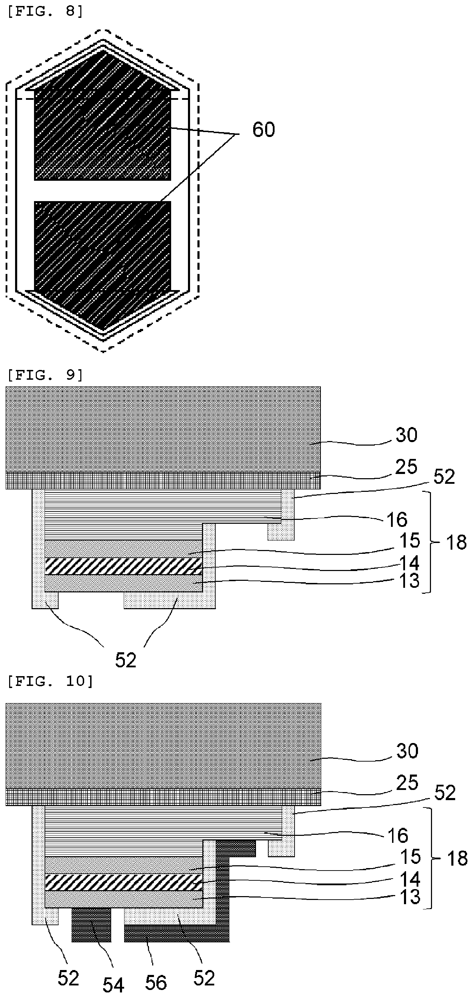

FIG. 8 shows a relation between the light emitting device shown in FIG. 5 and a position where a contact pad 60 is arranged.

According to the method for producing a light emitting device, the light emitting device in the hexagonal shape specified as described above can be produced. Thereby the yield of the light emitting device per a single wafer can be improved compared to the rectangular light emitting device. In addition, by setting the length of the parallel sides longer than the other sides, the generation of short circuit can be suppressed due to misalignment during mounting. Moreover, when the vertex angle is 90° or more, the mechanical strength of the vertex portion of the triangular shape can be prevented from weakening, and cracking at the triangular shape portion can be suppressed.

Furthermore, the two vertex angles (α and β) described above are preferably 90° or more and 120° or less. By setting the vertex angles within this range, the yield of the light emitting device per a single wafer can be further improved. Moreover, the area ratio of the light emitting layer to the total area of the device having the light emitting layer can be further increased. When the vertex angle is smaller than 90°, the triangular portion protrudes too much and thus decreases the mechanical strength and, therefore, cannot withstand stress when electrically connected to mounting electrodes, and is prone to chipping and cracking in the protrusion. When the vertex angle is 90° or more, such die breakage is unlikely to occur.

Moreover, a distance between the two sides (A and B) parallel to the symmetry axis SA is set to 1 µm or more and 100 µm or less; when a small light emitting device, i.e., a micro-LED, is produced, the present invention is particularly effective.

After performing the steps in FIGs 1 to 4 and performing the device isolation processing, it is preferred to form a protective film 52 as end surface processing as shown in FIG. 9 (FIG. 9). As the protective film 52, for example, SiO₂ can be used, but the film is not limited to SiO₂, any material can be selected as long as the material can protect the end surface and has an insulating property. SiNₓ, titanium oxide, magnesium oxide, and the like can be selected.

Then, as shown in FIG. 10, the electrode (upper electrode 54) in contact with the first conductivity-type layer (first cladding layer 13 in FIG. 10) and the electrode (lower electrode 56) in contact with the second conductivity-type layer (window layer 16 in FIG. 10) are formed, and then ohmic contact can be formed by performing heat treatment (FIG. 10). For example, it is possible to design the first conductivity-type as n-type and the second conductivity-type as p-type, and then to use a metal containing, for example, Au and Si for the electrode in contact with an n-type layer, and a metal containing, for example, Au and Be for the electrode in contact a P-type layer. The metal of the n-type electrode is not limited to Au and Si, and the same result can be obtained by using metals containing Au and Ge. In addition, the metal of the p-type electrode is not limited to Au and Be, and the same result can be obtained by using metals containing Au and Zn.

This embodiment (first embodiment), in which the devices with electrodes formed thereon are bonded via BCB, can be provided as a product for EZ-PETAMP step described above. After the light emitting device is adhered via silicone to a template substrate, being a synthetic quartz substrate subjected to convex pattern processing thereon, BCB is sublimated by laser irradiation from the to-be-bonded substrate side, and then the device is transferred from the to-be-bonded substrate to the template substrate. The transferred device is then re-transferred to a mounting substrate having a drive circuit to form an RGB display device.

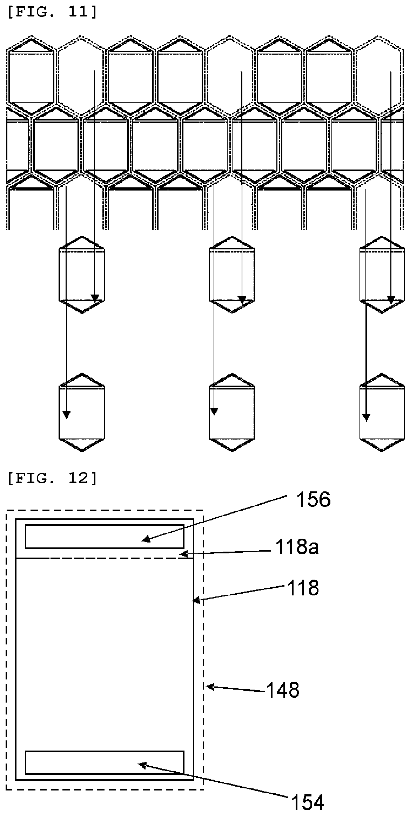

When the device is transferred to the mounting substrate, the devices are transferred discretely in both the horizontal and vertical directions, as shown schematically in FIG. 11. This is because a formation pitch of the micro-LED and that of the mounting side are generally different when forming the RGB display device.

### (Second Embodiment)

Next, the second embodiment of the present invention is described. In this embodiment, e.g., a first conductivity-type GaN buffer layer is grown on, e.g., a transparent sapphire starting substrate, then the epitaxial wafer is provided with a light-emitting device structure as the epitaxial functional layer in which, e.g., a first conductivity-type GaN first cladding layer having a thickness of 1.0 µm, e.g., a non-doped InGaN active layer, e.g., a second conductivity-type AlGaN second cladding layer having a thickness of 0.5 µm, e.g., and a second conductivity-type GaN window layer having a thickness of 6µm are sequentially grown. At this point, from the first cladding layer to the second cladding layer is referred to as a DH structure potion.

The step in which a pattern is subsequently formed by a photolithography method and then device isolation processing and exposure processing are performed by ICP is the same as that of the first embodiment.

After processing the device isolation, a protective film forming step and structure, as end surface processing, are the same as those of the first embodiment.

After forming the protective film as in the first embodiment, electrodes are formed to form an ohmic contact. Unlike the first embodiment, Ti/Al/Ni/Au, etc., are used for the electrodes.

A transferring method or a mounting method after the electrode formation is the same as in the first embodiment in that a laser is irradiated from a transparent substrate such as a sapphire substrate, but it is different from the first embodiment in which a GaN buffer layer portion is sublimated and delaminated instead of sublimating BCB.

### EXAMPLE

Hereinafter, the present invention will be described in detail with reference to Example and Comparative Example. However, the present invention is not limited thereto.

### (Example)

First, as shown in FIG. 1, an epitaxial layer, including a light-emitting layer, was grown on a starting substrate. Specifically, the following were implemented. To begin with, after laminating an n-type GaAs buffer layer on an n-type GaAs starting substrate 11, an etching stop layer 12 was formed thereon by forming an n-type GaInP first etching stop layer having a thickness of 0.1 µm and an n-type GaAs second etching stop layer having a thickness of 0.1 µm. An epitaxial wafer 20 was provided with a light emitting layer (light emitting device structure) as an epitaxial functional layer in which an n-type AlGaInP first cladding layer 13 having a thickness of 1.0 µm, a non-doped AlGaInP active layer 14, a p-type AlGaInP second cladding layer 15 having a thickness of 1.0 µm, and a p-type GaInP intermediate layer having a thickness of 0.1 µm (not shown), further, a p-type GaP window layer 16 having a thickness of 6 µm were sequentially grown on the etching stop layer 12 (FIG. 1).

Next, as shown in FIG. 2, the epitaxial wafer 20 is spin-coated thereon with benzocyclobutene (BCB) as a bonding material 25, and then by facing, superimposing, and bonding to a sapphire wafer, being a transparent substrate 30, under bonding conditions of 2 N/cm² and 250°C, a first epitaxial bonded substrate was produced (FIG. 2). When BCB was coated by spin-coating, a designed film thickness was 0.6 µm.

Then, as shown in FIG. 3, the GaAs starting substrate 11 was removed by wet etching to expose the first etching stop layer, and then the etchant was switched to remove the second etching stop layer, thereby removing the etching stop layer 12. Consequently, the first cladding layer 13 was exposed to produce a second epitaxial bonded substrate (FIG. 3).

Next, as shown in FIG. 4, a pattern was formed by a photolithography method, and device isolation processing was performed by ICP. Gases used for ICP were chlorine and argon, and the ICP processing was performed twice, including the device isolation step to expose the BCB layer 25 and the exposure step to expose the GaP window layer 16 (FIG. 4). Thereby, an isolation groove 47 for device formation was formed in the light emitting layer.

When the device isolation step was performed, as shown in FIGs 5 to 7, a plane view shape of the devices was a shape of a line-symmetric hexagon having a symmetry axis SA with two sides parallel to the symmetry axis SA (side A and side B), in which length of the two parallel sides (side A and side B) was longer than that of other four sides (sides C to F) and two vertex angles (α and β) through which the symmetry axis SA passed were 120° (FIGs 5 to 7).

Concrete dimensions of the device were: a distance between the vertex portion (vertex angle α) and the vertex portion (vertex angle β) on the symmetry axis SA was 13.50 µm, a distance between the parallel side A and side B was 7.79 µm, and an area of one device isolated by the device isolation groove 47 was 87.64 µm².

Electrodes were provided in an isosceles triangle portion within the hexagonal shape (upper electrode 54 and lower electrode 56) as shown in FIG. 5. In FIG. 5, ohmic contact electrodes described later were provided adjacent to an area having 120° degree angular shape (area including the vertex angle α and the vertex angle β shown in FIG. 6). A distance between the electrode and an outer edge portion of a die was determined by tolerance during photolithography, and in this Example, the tolerance was 0.25 µm. Each ohmic contact electrode area was 6.93 µm², and a distance between the electrodes was 9.00 µm.

In this Example, the isolation width between the devices was set to 0.87 µm, and a shape portion indicated by a dashed line in FIG. 5 corresponded to an intermediate line between the devices (device isolation intermediate line 48). The area inside the dashed line was an area required for device production, and that area was 103.92 µm² with a width of 8.66 µm and a distance of 14.50 µm between the vertex portion to the vertex portion on the symmetry axis SA.

Each device in the hexagonal shape was arranged as shown in FIG. 7, and each device shape included the vertex portions of the isosceles triangle. Thus, the devices arranged vertically were shifted by half a length from each other. FIG. 8 shows an arrangement of contact pads 60 with a mounting substrate provided on the device shown in FIG. 5. An alignment tolerance at the time of contact pad 60 formation was 0.25 µm, and a width from an electrode edge portion (vertical direction in the drawing) was 4.00 µm, a clearance between the electrodes having a different polarity was 1.00 µm.

After the device isolation processing, a SiO₂ protective film 52 was formed as end surface processing (FIG. 9). Subsequently, the electrode in contact with an n-type layer and the electrode in contact with a p-type layer (upper electrode 54 and lower electrode 56) were formed to form an ohmic contact by performing heat treatment (FIG. 10).

### (Comparative Example)

A light emitting device was formed in the same way as in Example, except that a device isolation pattern was rectangular (FIG. 12).

A shape of the light emitting device had a distance of 11.25 µm in a major axis direction, a width of 7.79 µm in a minor axis direction, and an area of the device isolated by a device isolation groove was 87.64 µm², which was the same as in Example.

A distance between the electrodes (upper electrode 154 and lower electrode 156) and an outer edge portion of a device 118 was determined by tolerance during photolithography, but the tolerance was 0.25 µm as in Example. Note that FIG. 12 also shows an underlayer exposed region 118a. Each ohmic contact electrode area was 6.93 µm² as in Example, and a distance between the electrodes was 8.75 µm.

As in Example, the isolation width between devices was set to 0.87 µm, and an area required for a device production indicated by a dashed line (device isolation intermediate line 148) in FIG. 12 was 104.96 µm² with a width of 8.66 µm and a distance of 12.12 µm in a major axis direction. In this way, when a similar design as in Example was used, the area required for the device production in Comparative Example became larger than that of Example.

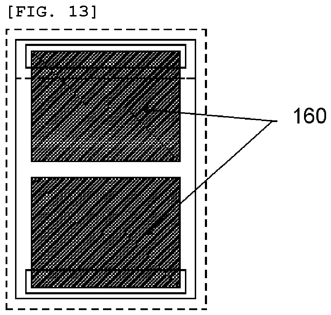

FIG. 13 shows an arrangement of contact pads 160 with a mounting substrate provided on FIG. 12. An alignment tolerance at the time of contact pad 160 formation was 0.25 µm, a width from an electrode edge portion (vertical direction in the drawing) was 4.00 µm, and a clearance between the electrodes having a different polarity was 0.75 µm. As the distance between the electrodes in Example was 1.00 µm, the clearance between the contact pads in Comparative Example was smaller than that in Example with the same design. When the clearance was shorter, a short circuit was prone to generate during mounting due to misalignment, thereby making a required alignment tolerance more stringent. Therefore, the clearance between the electrodes was required to be set large enough to meet the alignment tolerance, and the die in Comparative Example needed to be longer in the major axis direction than that in Example to meet the alignment tolerance. Consequently, the required die area is necessarily larger than that of Example.

In Comparative Example, the area of the light emitting device was set to the same as that in Example, but when making it consistent with the required tolerance necessary during mounting, it was impossible to design the die with the same size as in Comparative Example; the die needed to be long in the major axis direction, and the area required for a die formation necessarily needed to be designed to be larger than in Example. When the clearance of the contact pads was set to 1.00 µm, the same as Example, the die was required to be extended by 0.25 µm from 11.25 µm to 11.50 µm in the major axis direction, and the die area required to achieve the same alignment as in Example was required to be increased by 2.2% from 87.64 µm² to 89.59 µm². As a result, an area required for device production (corresponding to an area inside the device isolation intermediate line 148 indicated by the dashed line) increased by 2.9% from 104.96 µm² to 108.00 µm². When compared with Example, this area was 3.9% larger. Consequently, a die yield per a single wafer was lowered than that of Example.

### (Comparison of Example and Comparative Example)

In FIG. 5, being Example, the width of the light emitting device is 7.79 µm, and a plane view area of the light emitting device is 87.64 µm². A distance (width) to the intermediate line (device isolation intermediate line 48) of a distance to an adjacent device indicated by the dashed line is 0.43 µm (the distance to the adjacent die was 0.86 µm). In this case, the area required per one light emitting device is a region enclosed by the intermediate line (the region enclosed by the device isolation intermediate line 48 indicated by the dashed line). The area of the region enclosed by this device isolation intermediate line 48 is 103.92 µm². When the rectangular device in Comparative Example shown in FIG. 12 is arranged while maintaining a clearance rule, the region enclosed by the device isolation intermediate line 148 is found to be 104.96 µm² when the areas of the light emitting devices are identical, and the design in Example has 1.00% smaller area than that in the rectangular case (Comparative Example).

As described above, a difference of 1.00% is observed in the light emitting device areas, but a difference is also observed in the comparison of effective light emitting layer areas.

Although underlayers are exposed to form ohmic contact layers in both Example and Comparative Example (shown as underlayer exposed region 18a in FIG. 5, and underlayer exposed region 118a in FIG. 12), the ohmic contact electrodes (lower electrode 56 and lower electrode 156 in Example and Comparative Example, respectively) are formed in contact with the exposed underlayers. In FIGs. 5 and 12, the electrode areas in contact with the underlayers are standardized to 6.93 µm², respectively.

In FIG. 5 of Example, the electrode is triangular, and in FIG. 12 of Comparative Example, the electrode is rectangular. The vertical and horizontal distances from the edge of the device isolation (alignment tolerance in the photolithography step) are standardized to be 0.25 µm, which is the same rule in the examples described above.

In this case, the light emitting layer remains in the region other than the area, which is cut off to expose the underlayer, and the area of the remaining light emitting layer contributes to effective light emitting. This area is 75.49 µm² in Example, and 74.55 µm² in Comparative Example, and thus a difference of about 1.25% is observed. Various characteristics of an LED are determined by a current density injected into the light emitting layer. The current density is determined by the area of the light emitting layer and the amount of electric power injected into the active layer; therefore, it is not the area of an entire die that determines the characteristics of the LED, but the area of the light emitting layer.

That is, by using a technique of the present invention, an overall area of the light emitting device can be reduced compared to the conventional technique, and occupancy area required for production of the light emitting device can be reduced.

Note that the above described effect to make the difference in the light emitting layer while maintaining the die area evenly is most effective when the electrode in contact with the underlayer has a triangular shape instead of a quadrangular or trapezoidal shape.

In addition, although the case where the die areas are standardized is exemplified, the area of the light emitting layer portion is larger in Example when the die areas are standardized, and it is clear that the die area can be smaller than that of the die of the conventional technique when the technique of the present invention is used. Therefore, when this technique is applied by standardizing the light emitting layer area as in the conventional technique instead of the die area, the actions and effects of this technique become larger than the effect shown here. The same effect can be obtained when making the light emitting device area smaller by matching the light emitting layer areas instead of matching the light emitting device areas.

The present description includes the following embodiments.
[1]: A method for producing a light emitting device to produce a plurality of light emitting devices, the method comprising the steps of:
   growing an epitaxial layer including a light emitting layer on a starting substrate; and
   forming an isolation groove for device formation in the light emitting layer, wherein
   respective plane view shapes of the plurality of the light emitting devices to be produced are line-symmetric hexagons having a symmetry axis with two sides parallel to the symmetry axis, in which length of the two parallel sides is longer than that of other four sides and two vertex angles through which the symmetry axis passes are 90° or more and less than 180°, and
   the plurality of the light emitting devices to be produced are isolated by the isolation groove of a predetermined width, and the isolation groove is formed so as to arrange the plurality of light emitting devices without a gap via the isolation groove.
[2]: The method for producing a light emitting device of the above [1], wherein
   after the step of growing the epitaxial layer, the method further comprises a step of bonding a transparent substrate to the epitaxial layer via a bonding material and removing the starting substrate.
[3]: The method for producing a light emitting device of the above [1] or [2], wherein
   the two vertex angles are 90° or more and 120° or less.
[4]: The method for producing a light emitting device of the above [1], [2] or [3], wherein
   a distance between the two sides parallel to the symmetry axis is 1 µm or more and 100 µm or less.
[5]: The method for producing a light emitting device of the above [1], [2], [3] or [4], wherein
   the isolation groove is formed by an ICP dry etching method.
[6]: The method for producing a light emitting device of the above [2], [3], [4] or [5], wherein
   the transparent substrate is any of sapphire, quartz, or glass.
[7]: The method for producing a light emitting device of the above [2], [3], [4], [5] or [6], wherein
   the bonding material is at least any of benzocyclobutene, fluororesin, or epoxy resin.
[8]: A light emitting device, wherein
   the light emitting device has a shape having a plane view shape of a line-symmetric hexagon with a symmetry axis, two sides parallel to the symmetry axis, length of the two parallel sides longer than that of other four sides, and two vertex angles through which the symmetry axis passes being 90° or more and less than 180°.
[9]: The light emitting device of the above [8], wherein
   the light emitting device is bonded to a transparent substrate via a bonding material.
[10]: The light emitting device of the above [8] or [9], wherein
   the two vertex angles are 90° or more and 120° or less.
[11]: The light emitting device of the above [8], [9] or [10], wherein
   a distance between the two sides parallel to the symmetry axis is 1 µm or more and 100 µm or less.
[12]: The light emitting device of the above [9], [10] or [11], wherein
   the transparent substrate is any of sapphire, quartz, or glass.
[13]: The light emitting device of the above [9], [10], [11] or [12], wherein
   the bonding material is at least any of benzocyclobutene, fluororesin, or epoxy resin.

It should be noted that the present invention is not limited to the above-described embodiments. The embodiments are just examples, and any examples that have substantially the same feature and demonstrate the same functions and effects as those in the technical concept disclosed in claims of the present invention are included in the technical scope of the present invention.

## Claims

1. A method for producing a light emitting device to produce a plurality of light emitting devices, the method comprising the steps of:
growing an epitaxial layer including a light emitting layer on a starting substrate; and
forming an isolation groove for device formation in the light emitting layer, wherein
after the step of growing the epitaxial layer, the method further comprises a step of bonding a transparent substrate to the epitaxial layer via a bonding material and removing the starting substrate,
respective plane view shapes of the plurality of the light emitting devices to be produced are line-symmetric hexagons having a symmetry axis with two sides parallel to the symmetry axis, in which length of the two parallel sides is longer than that of other four sides and two vertex angles through which the symmetry axis passes are 90° or more and less than 180°, and
the plurality of the light emitting devices to be produced are isolated by the isolation groove of a predetermined width, and the isolation groove is formed so as to arrange the plurality of light emitting devices without a gap via the isolation groove.

2. The method for producing a light emitting device according to claim 1, wherein
the two vertex angles are 90° or more and 120° or less.

3. The method for producing a light emitting device according to claim 1 or 2, wherein
a distance between the two sides parallel to the symmetry axis is 1 µm or more and 100 µm or less.

4. The method for producing a light emitting device according to claim 1 or 2, wherein
the isolation groove is formed by an ICP dry etching method.

5. The method for producing a light emitting device according to claim 1, wherein
the transparent substrate is any of sapphire, quartz, or glass.

6. The method for producing a light emitting device according to claim 1, wherein
the bonding material is at least any of benzocyclobutene, fluororesin, or epoxy resin.

7. A light emitting device, wherein
the light emitting device has a shape having a plane view shape of a line-symmetric hexagon with a symmetry axis, two sides parallel to the symmetry axis, length of the two parallel sides longer than that of other four sides, and two vertex angles through which the symmetry axis passes being 90° or more and less than 180°, and
the light emitting device is bonded to a transparent substrate via a bonding material.

8. The light emitting device according to claim 7, wherein
the two vertex angles are 90° or more and 120° or less.

9. The light emitting device according to claim 7 or 8, wherein
a distance between the two sides parallel to the symmetry axis is 1 µm or more and 100 µm or less.

10. The light emitting device according to claim 7, wherein
the transparent substrate is any of sapphire, quartz, or glass.

11. The light emitting device according to claim 7, wherein
the bonding material is at least any of benzocyclobutene, fluororesin, or epoxy resin.
